# EUROPÄISCHE PATENTANMELDUNG

(11) **EP 4 835 934 A1**
(43) Veröffentlichungstag der Anmeldung: **04.11.2026**
(21) Anmeldenummer: 26170549.5
(22) Anmeldetag: 02.04.2026
(51) Int. Cl.: H01H 13/10, H01H 13/06, H01H 13/86, G01R 1/04, H01H 9/04, H01H 13/14, H01H 13/52, H05K 5/00

(54) **SCHALTBAUGRUPPE EINES ELEKTRONISCHEN MESSGERÄTES**

(30) Priorität: 28.04.2025 DE 102025116141
(71) Anmelder: Robert Bosch GmbH, 70442 Stuttgart (DE)
(72) Erfinder: Chan, Chi Fung, 73760 Ostfildern (DE); Ying, Jianbang, Hangzhou, Zhejiang, 311400 (CN); Zhang, Xinhui, Hangzhou, 311400 (CN); Moren, Gaetan, 70197 Stuttgart (DE)

(57) **Zusammenfassung**

Die Erfindung bezieht sich auf eine Schaltbaugruppe (43) eines elektronischen Messgerätes (10), die in einer seitlichen Position (32) in einem Gehäuse (24) des elektronischen Messgerätes (10), insbesondere zu einer Gehäuseöffnung (72) fluchtend, angeordnet ist. Die Schaltbaugruppe (43) umfasst einen Schaltknopf (68) und eine Halteplatte (46), die in Aufnahmen (64), insbesondere Führungsschienen, des Gehäuses (24) geführt ist und an der eine Leiterplatine (62) aufgenommen ist.

## Beschreibung

### Technisches Gebiet

Die Erfindung bezieht sich auf eine Schaltbaugruppe eines elektronischen Messgerätes, die einer seitlichen Position in einem Gehäuse des elektronischen Messgerätes, insbesondere zu einer Gehäuseöffnung fluchtend, untergebracht ist.

### Stand der Technik

Manuell handhabbare elektronische Messgeräte, wie beispielsweise Multimeter, Voltmeter oder Strommessgeräte, erfordern ein möglichst geringes Gewicht, um die Handhabung durch den Bediener zu vereinfachen. Derartige elektronische Messgeräte weisen in der Regel einen Wahlschalter auf, mit welchem ein Betriebsmodus des elektronischen Messgerätes durch den Bediener manuell ausgewählt werden kann. So kann beispielsweise mittels eines verdrehbaren Schaltrades am elektronischen Messgerät zwischen Spannungsmessung, Strommessung und Widerstandsmessung und der Messung weiterer elektrischer Größen ausgewählt werden.

Derartige an elektronischen Messgeräten vorgesehene Wahlschalter werden über Rastelemente in den jeweils durch den Bediener ausgewählten Positionen temporär arretiert. Der Bediener verdreht den Wahlschalter entsprechend der von ihm gewünschten Position in Umfangsrichtung. Dabei rastet der verdrehbare Wahlschalter in bestimmten Umfangslagen entsprechend dem ausgewählten Betriebsmodus ein und bleibt in dieser Umfangslage temporär arretiert.

Zur Bestimmung der jeweils definierten Drehlage und zur Verbesserung der Haptik durch den Bediener ist es erforderlich, dass die ausgewählten Drehlagen eindeutig ausgewählt werden können und kein schwammiges Verhalten auftritt, bei dem die Drehlage des Wahlschalters nicht eindeutig definiert ist. Des Weiteren sollte der verdrehbare Wahlschalter zwischen den einzelnen definierten Drehlagen eindeutig und mit möglichst wenig Reibung verdrehbar sein, um den Bediener bei der Handhabung zu unterstützen.

Derartige, manuell bedienbare elektronische Messgeräte sollten neben einer benutzerfreundlichen Handhabung auch eine geringe Bauhöhe aufweisen, die das Umgreifen und somit eine einhändige Handhabung des elektronischen Messgerätes vereinfachen.

### Offenbarung der Erfindung

Erfindungsgemäß wird eine Schaltbaugruppe eines elektronischen Messgerätes vorgeschlagen, die in einer seitlichen Position in einem Gehäuse des elektronischen Messgerätes, insbesondere zu einer Gehäuseöffnung fluchtend, untergebracht ist. Die Schaltbaugruppe umfasst einen Schaltknopf und eine Halteplatte, die in Aufnahmen, insbesondere Führungsschienen, im Gehäuse geführt ist und an der eine Schaltplatine aufgenommen ist.

Bei der erfindungsgemäß vorgeschlagenen Lösung ist vorgesehen, dass das Gehäuse Aufnahmen, insbesondere Führungsschienen, aufweist, in denen sowohl die Schaltplatine als auch die Halteplatte aufgenommen sind.

In vorteilhafter Weise ist die erfindungsgemäß vorgeschlagene Schaltbaugruppe derart ausgebildet, dass die Schaltplatine einen einer beispielsweise stempelförmig ausgeführten Fläche des Schaltknopfes gegenüberliegenden Mikroschalter aufweist.

In vorteilhafter Weise ist die erfindungsgemäß vorgeschlagene Schaltbaugruppe derart ausgebildet, dass der Mikroschalter auf einer Oberseite eines Podestes der Schaltplatine aufgenommen ist.

In vorteilhafter Weiterbildung der erfindungsgemäß vorgeschlagenen Schaltbaugruppe ist vorgesehen, dass der Schaltknopf eine umlaufende Vertiefung aufweist, die durch einen umlaufenden Bund begrenzt ist.

Durch die Einbauposition der erfindungsgemäß vorgeschlagenen Schaltbaugruppe im Gehäuse des elektronischen Messgerätes bilden der umlaufende Bund des Schaltknopfes und die umlaufende Vertiefung desselben mit einer die Gehäuseöffnung am Gehäuse begrenzenden Wand eine Labyrinthdichtung.

Die erfindungsgemäß vorgeschlagene Schaltbaugruppe zeichnet sich des Weiteren dadurch aus, dass die Schaltplatine an der Halteplatte mittels Fixierhaken fixiert ist.

Des Weiteren ist die erfindungsgemäß vorgeschlagene Schaltbaugruppe in vorteilhafter Weise derart ausgestaltet, dass die Schaltplatine derart fixiert ist, dass diese innerhalb eines XYZ-Koordinatensystems im Wesentlichen unbeweglich in ihrer Position fixiert ist.

Die erfindungsgemäß vorgeschlagene Schaltbaugruppe wird in einem elektronischen Messgerät verwendet, welches als Multimeter, als Zangenamperemeter, als Gabelamperemeter oder als Spannungsmesser zur Messung elektrischer Größen ausgeführt ist, insbesondere von Strömen, Spannungen, elektrischen Widerständen, Kapazitäten, Temperaturen, Impedanzen, in Gleichstrom- oder Wechselstromanwendungen.

Des Weiteren bezieht sich die Erfindung auf ein elektronisches Messgerät mit einer erfindungsgemäßen Schaltbaugruppe.

### Vorteile der Erfindung

Die erfindungsgemäß vorgeschlagene Lösung zeichnet sich einerseits durch ihre kostengünstige Herstellbarkeit aus und bildet durch die Ausbildung des umlaufenden Bundes und der umlaufenden Vertiefung im nachgiebigen, beispielsweise im Gummimaterial des Schaltknopfes, mit der die Gehäuseöffnung begrenzenden Gehäusewand eine Labyrinthdichtung. Dadurch kann das Eintreten von Feuchtigkeit und Schmutzpartikeln über die Gehäuseöffnung in das Innere des Gehäuses des elektronischen Messgerätes wirksam verhindert werden. Durch die erfindungsgemäß vorgeschlagene Schaltbaugruppe ist weiterhin eine unmittelbare Betätigung des Mikroschalters gegeben, der auf der Oberseite der Schaltplatine auf einem Podest untergebracht ist. Unter Podest ist in diesem Zusammenhang eine auf der Oberseite der Schaltplatine angebrachte, hervorstehende Erhebung zu verstehen, auf deren Oberfläche sich der Mikroschalter befindet. Dieser befindet sich mithin auf einem höheren Niveau als die das Podest an der Oberseite der Schaltplatine umgebende Fläche.

Durch die Unterbringung des aus nachgiebigem Material, wie beispielsweise Gummi, gefertigten Schaltknopfes in der Gehäuseöffnung wird dieser seitlich in der Gehäuseöffnung geführt, und es besteht für den Schaltknopf nur ein Bewegungsfreiheitsgrad, nämlich in Richtung auf die Schaltplatine. Unter einer seitlichen Positionierung am Gehäuse ist in diesem Zusammenhang zu verstehen, dass sich der Schaltknopf an einer Seite und nicht an der Vorder- oder Rückseite des Gehäuses des vorgeschlagenen elektronischen Messgerätes befindet.

In vorteilhafter Weise ist bei der erfindungsgemäß vorgeschlagenen Schaltbaugruppe vorgesehen, dass die Schaltplatine unmittelbar einer stempelförmigen Fläche des Schaltknopfes gegenüberliegend angeordnet ist, wodurch sich eine unmittelbare Betätigung des auf der Schaltplatine angeordneten Mikroschalters ergibt.

### Kurze Beschreibung der Zeichnungen

Ausführungsformen der Erfindung werden anhand der Zeichnungen und der nachfolgenden Beschreibung näher erläutert.

Es zeigen:
- Figuren 1 und 2: perspektivische Ansichten von elektronischen Messgeräten,
- Figur 3: eine Draufsicht auf ein teilweise geöffnetes Gehäuse eines elektronischen Messgerätes,
- Figur 4: eine Zusammenbau-Zeichnung der erfindungsgemäß vorgeschlagenen Schaltbaugruppe,
- Figur 4.1: die Halteplatte in perspektivischer Ansicht,
- Figur 4.2: die Schaltplatine in perspektivischer Ansicht,
- Figur 4.3: das Gehäuse mit darin ausgebildeten Führungsflächen in perspektivischer Ansicht,
- Figur 4.4: den Schaltknopf der Schaltbaugruppe in perspektivischer Ansicht und
- Figur 5: eine Schnittdarstellung der in der Gehäuseöffnung montierten Schaltbaugruppe samt Schaltknopf.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

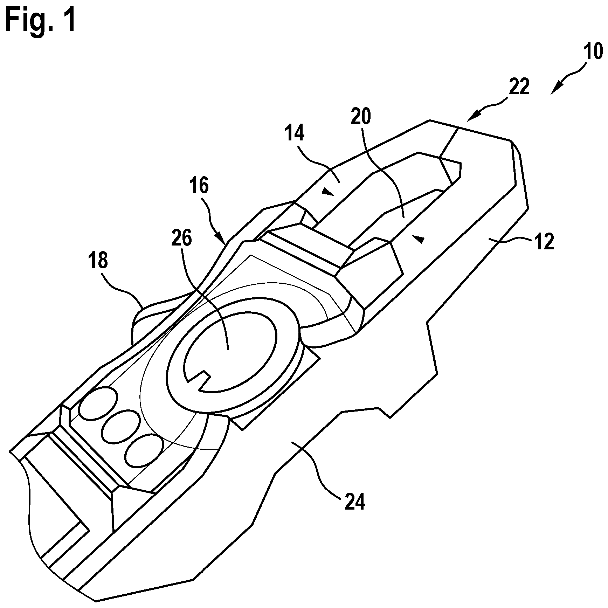

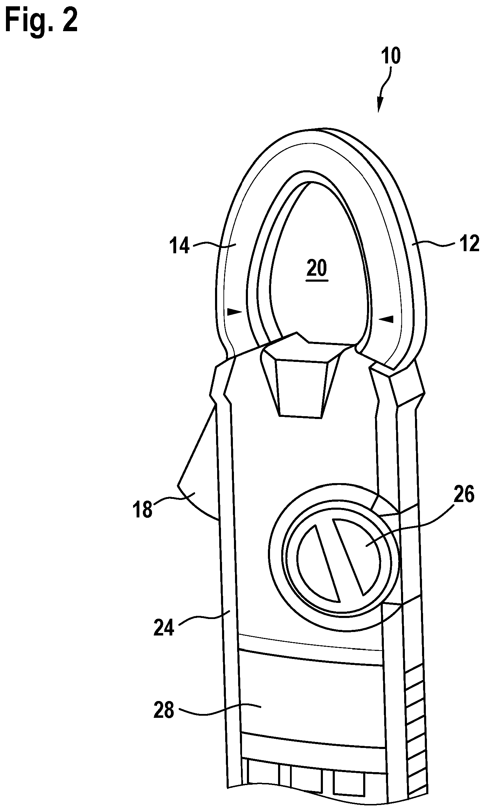

Die Figuren 1 und 2 zeigen elektronische Messgeräte 10, jeweils in perspektivischer Darstellung.

Der Darstellung gemäß Figur 1 ist ein elektronisches Messgerät 10 zu entnehmen, welches einen stationären Schenkel 12 sowie einen relativ zu diesem bewegbaren Schenkel 14 aufweist. Der bewegbare Schenkel 14 ist um ein Gelenk 16 bewegbar. Am elektronischen Messgerät 10 befindet sich seitlich ferner ein Auslöser 18, mit welchem der Betrieb des elektronischen Messgerätes 10 aktiviert werden kann. In der in Figur 1 dargestellten geschlossenen Position 22 des stationären Schenkels 12 und des bewegbaren Schenkels 14 begrenzen diese ein Auge 20 beziehungsweise einen Freiraum, durch welchen sich ein stromführender oder ein spannungsführender elektrischer Leiter zur kontaktlosen Messung elektrischer Größen erstreckt. Es sei darauf hingewiesen, dass hier auch weitere elektronische Messgeräte 10 wie Gabelamperemeter, Multimeter oder Feuchtigkeitsmessgeräte sowie Spannungsmesser und dergleichen umfasst sind. Das elektronische Messgerät 10 umfasst ein Gehäuse 24, in dem eine Auswerteelektronik sowie ein Display und dergleichen untergebracht sind, ebenso wie eine Energiequelle in Gestalt einer Batterie oder eines wiederaufladbaren Akkumulators oder eines Akkupacks. Auf der in der perspektivischen Darstellung gemäß Figur 1 dargestellten Gehäuseoberseite befindet sich ein verdrehbarer Wahlschalter 26. Der verdrehbare Wahlschalter 26 umfasst einen Außenumfang, welcher mit einer Profilierung versehen ist, so dass der verdrehbare Wahlschalter 26 in Umfangsrichtung um eine Drehachse verdreht werden kann, um zwischen verschiedenen Betriebsmodi des elektronischen Messgerätes 10 hin und her zu schalten. Die Profilierung ist am Außenumfang des verdrehbaren Wahlschalters 26 so beschaffen, dass diese auch mit einem Schutzhandschuh betätigt werden kann.

Der Draufsicht gemäß Figur 2 ist ein elektronisches Messgerät 10 zu entnehmen, dessen stationärer Schenkel 12 und dessen bewegbarer Schenkel 14 ebenfalls eine geschlossene Position 22 einnehmen und ein Auge 20 begrenzen. Der auf der Vorderseite des elektronischen Messgerätes 10 dargestellte verdrehbare Wahlschalter 26 ist in eine Anzahl von Drehlagen, die entsprechenden Betriebsmodi zugeordnet sind, verdrehbar. So kann das elektronische Messgerät 10 zur Widerstandsmessung, zur Gleich- oder Wechselspannungsmessung und auch zur Messung von Strömen eingesetzt werden.

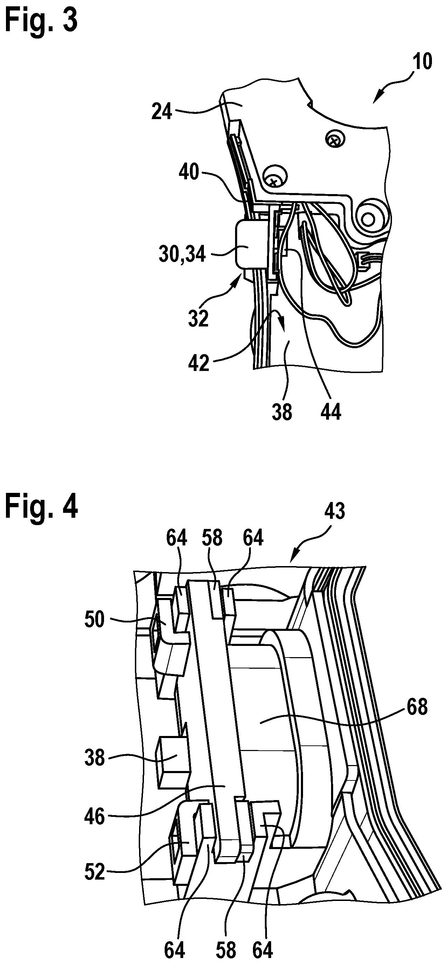

Figur 3 zeigt eine elektronisches Messgerät 10 mit teilweise geöffnetem Gehäuse.

Aus der Draufsicht gemäß Figur 3 geht hervor, dass im Gehäuse 24 des teilweise aufgeschnittenen elektronischen Messgerätes 10 eine Leiterplatte 38 angeordnet ist. Auf dieser befindet sich auf einer Oberseite 42 ein Mikroschalter 44. Dieser ist über einen in einer seitlichen Position 32 angeordneten seitlichen Schalter 34 betätigbar. In der Darstellung gemäß Figur 3 ist der Betätigungsschalter 30 als seitlicher Schalter 34 im Gehäuse 24 untergebracht und stützt sich an einer Gehäuserippe 40 des Gehäuses 24 des elektronischen Messgerätes 10 ab.

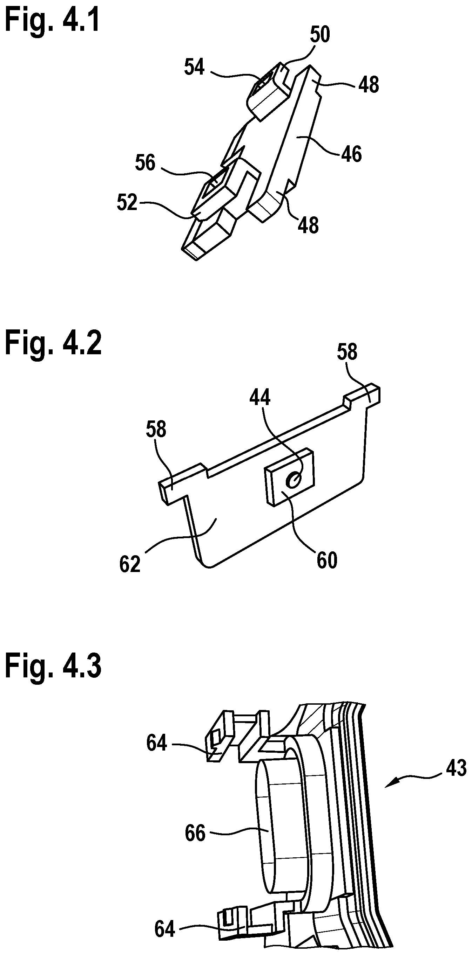

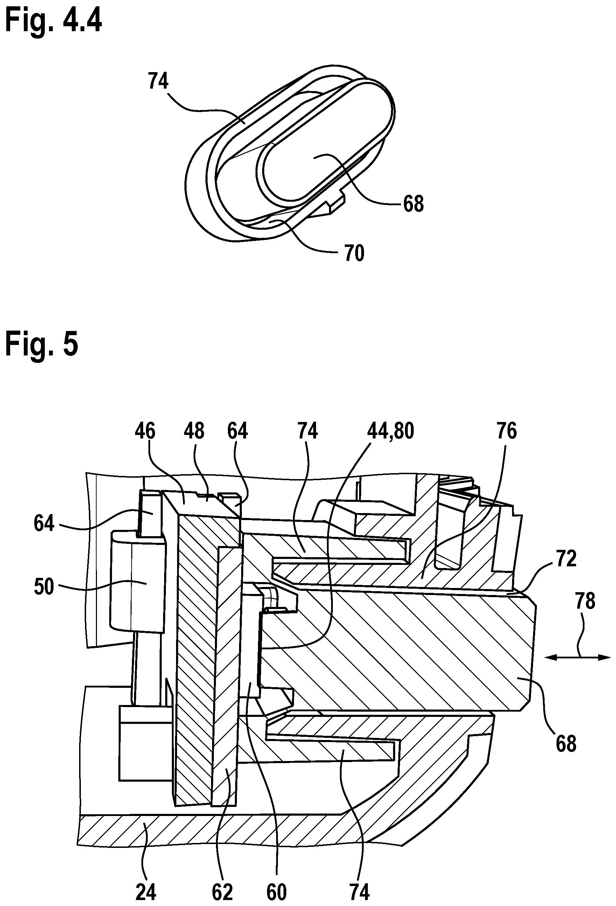

Die Figuren 4, 4.1, 4.2, 4.3 und 4.4 zeigen in perspektivischer Darstellung einzelne Komponenten einer Schaltbaugruppe 43, die im Gehäuse 24 des elektronischen Messgerätes 10 in der seitlichen Position 32 untergebracht ist.

Aus Figur 4 geht die Einbausituation der Schaltbaugruppe 43 im Gehäuse 24 des elektronischen Messgerätes 10 hervor. Die Schaltbaugruppe 43 umfasst gemäß Figur 4 einen aus einem elastischen Material, wie beispielsweise Gummi oder einem anderen, leicht verformbaren Kunststoff, gefertigten Schaltknopf 68. Darüber hinaus umfasst die Schaltbaugruppe 43 eine Halteplatte 46, an welcher eine Schaltplatine 62 aufgenommen ist. Die Schaltplatine 62 umfasst an ihren Kantenabsätzen 48 Fixierhaken 58, die an den Enden der Schaltplatine 62 verrastet sind. Die in Figur 4 dargestellte Schaltplatine 62 ist in Aufnahmen 64, insbesondere Führungsschienen, beidseitig geführt, die im Gehäuse 24 des elektronischen Messgerätes 10, ausgebildet als Kunststoffspritzgussbauteil, gelagert sind.

Aus der Darstellung gemäß Figur 4.1, die eine perspektivische Ansicht der Halteplatte 46 zeigt, geht hervor, dass auf einer Seite der Halteplatte 46, den Kantenabsätzen 48 gegenüberliegend, ein erster hakenförmiger Vorsprung 50 sowie diesem gegenüberliegend ein zweiter hakenförmiger Vorsprung 52 ausgeführt sind. Die beiden hakenförmig ausgebildeten ersten und zweiten Vorsprünge 50, 52 umfassen jeweils eine erste Öffnung 54 und eine zweite Öffnung 56. An den in der perspektivischen Darstellung gemäß Figur 4.1 dargestellten Kantenabsätzen 48 wird die in Figur 4.2 in perspektivischer Ansicht dargestellte Schaltplatine 62 an der Halteplatte 46 der Schaltbaugruppe 43 gemäß Figur 4 fixiert. Dies geschieht im Wesentlichen werkzeuglos durch einfaches Einklipsen der Fixierhaken 58 an den Kantenabsätzen 48 der Schaltplatine 62.

Figur 4.2 zeigt in perspektivischer Ansicht die Schaltplatine 62. Diese ist an ihren Rändern mit jeweils einem Fixierhaken 58 an einander gegenüberliegenden Seiten der Schaltplatine 62 versehen. Mit Hilfe der Fixierhaken 58 wird die Schaltplatine 62 an der in Figur 4.1 in perspektivischer Ansicht dargestellten Halteplatte 46 der Schaltbaugruppe 43 eingehängt. Auf einer Seite der Schaltplatine 62 gemäß Figur 4.2 befindet sich eine Erhebung in Gestalt eines Podestes 60. Auf der Oberseite des Podestes 60 ist der Mikroschalter 44 angeordnet. Der Mikroschalter 44 wird durch eine Fläche beziehungsweise einen Stempel 80, der am Schaltknopf 68 ausgebildet ist, betätigt. Die in Figur 4.2 in perspektivischer Ansicht dargestellte Schaltplatine 62 wird mittels der Fixierhaken 58 in die Kantenabsätze 48 an den seitlichen Enden der Halteplatte 46 gemäß Figur 4.1 eingehängt, was werkzeuglos geschieht.

Der Darstellung gemäß Figur 4.3 ist eine perspektivische Ansicht eines Teilbereiches des Gehäuses 24 mit darin aufgenommenen Teilen der Schaltbaugruppe 43 zu entnehmen. Im Gehäuse 24 ist eine ovale Öffnung 66 vorgesehen. Der Abstand zwischen der ovalen Öffnung 66 und dem in diese einzuführenden Schaltknopf 68 ist gering bemessen, um eine Kontamination des Gehäuseinneren 24 durch Feuchtigkeit oder Schmutzpartikel zu verhindern. Die ovale Öffnung 66 beziehungsweise deren Rand befindet sich unterhalb von Aufnahmen 64, insbesondere Führungsschienen, die ebenfalls im Gehäuse 24 ausgebildet sind. In die einander gegenüberliegend angeordneten, die seitlichen Enden der Halteplatte 46 umgreifenden Aufnahmen 64, insbesondere Führungsschienen, wird besagte Halteplatte 46 mit daran aufgenommener Schaltplatine 62 eingehängt.

Figur 4.4 zeigt eine perspektivische Ansicht des Schaltknopfes 68, der aus einem elastisch verformbaren Material, wie zum Beispiel Gummi, einer Gummimischung oder dergleichen, gefertigt ist. Der Schaltknopf 68 umfasst eine umlaufende Vertiefung 70 sowie einen, die umlaufende Vertiefung 70 begrenzenden, umlaufenden Bund 74.

Figur 5 zeigt die Schaltbaugruppe 43, teilweise geschnitten, im eingebauten Zustand in einer Gehäuseöffnung 72 des Gehäuses 24 des elektronischen Messgerätes 10.

Wie aus der Darstellung gemäß Figur 5 hervorgeht, bilden die Öffnungswände 76 der Gehäuseöffnung 72 mit der umlaufenden Vertiefung 70 einerseits und dem umlaufenden Bund 74 des Schaltknopfes 68 andererseits eine Dichtung nach Art einer Labyrinthdichtung. Somit kann von der Außenseite her keine Feuchtigkeit oder Schmutz in das Innere des Gehäuses 24 des elektronischen Messgerätes 10 gelangen. Die an einer Seite des Schaltknopfes 68 ausgebildete Fläche oder der Stempel 80 liegt dem Mikroschalter 44 gegenüber und betätigt diesen, sobald der Schaltknopf 68 in Betätigungsrichtung 78 (X-Richtung) ausgelenkt wird. Durch die relativ enge Führung des Schaltknopfes 68 in der Gehäuseöffnung 72 hat der Schaltknopf 68 lediglich einen Freiheitsgrad, der mit der Betätigungsrichtung 78 des Schaltknopfes 68 zusammenfällt.

Aus der Schnittdarstellung gemäß Figur 5 geht des Weiteren hervor, dass die Fläche oder der Stempel 80 am gehäuseseitigen Ende des Schaltknopfes 68 dem Mikroschalter 44 gegenüberliegt, und im Wesentlichen ein spielfreier Kontakt zwischen dem Mikroschalter 44 und der Fläche oder dem Stempel 80 am gehäuseseitigen Ende des Schaltknopfes 68 der Schaltbaugruppe 43 vorliegt.

Weiterhin lässt sich der Schnittdarstellung gemäß Figur 5 entnehmen, dass die hier geschnitten dargestellte Halteplatte 46 in der Aufnahme 64, insbesondere einer Führungsschiene, des Gehäuses 24 geführt ist, ferner auf einer Seite der Halteplatte 46 besagte Schaltplatine 62 fixiert ist. Auf der der Schaltplatine 62 abgewandten Seite der Halteplatte 46 ist in der Darstellung gemäß Figur 5 einer der Vorsprünge 50, 52, im vorliegenden Fall der erste Vorsprung 50, zu sehen. Dieser übergreift zumindest teilweise eine der Aufnahmen 64, insbesondere Führungsschienen, in der die Halteplatte 46, wie sie in Figur 4.1 dargestellt ist, seitlich im Gehäuse 24 fixiert ist.

Der Schaltknopf 68 liegt zumindest teilweise an der Halteplatte 46 an, insbesondere an einem Steg. Ferner liegt der Schaltknopf 68 der erfindungsgemäß vorgeschlagenen Schaltbaugruppe 43 zumindest teilweise an der Schaltplatine 62 an. Die Schaltplatine 62 wiederum ist zumindest teilweise zwischen der Halteplatte 46 und dem Schaltknopf 68 angeordnet. Ferner ist der Schaltknopf 68 durch eine ovale Öffnung 66, die in der Wandung des Gehäuses 24 ausgeführt ist, geführt. Am Schaltknopf 68 kann in vorteilhafter Weise eine stempelförmig ausgebildete Fläche 80 ausgeführt sein, die dem zu betätigenden Mikroschalter 44 gegenüberliegt. Ferner ist ein Teil des Gehäuses 24, insbesondere eine Öffnungswand 76, zumindest teilweise zwischen dem Körper des Schaltknopfs 68 und einem umlaufenden Bund 74 angeordnet. Die Toleranz zwischen der ovalen Öffnung 66 und dem Körper des Schaltknopfs 68 ist möglichst gering bemessen, um ein Eintreten von Feuchtigkeit oder Schmutz in das Innere des Gehäuses 24 zu verhindern.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Schaltbaugruppe (43) eines elektronischen Messgerätes (10), die in einer seitlichen Position in einem Gehäuse (24) des elektronischen Messgerätes (10), insbesondere zu einer Gehäuseöffnung (72) fluchtend, untergebracht ist, **dadurch gekennzeichnet, dass** die Schaltbaugruppe (43) einen Schaltknopf (68) und eine Halteplatte (46) umfasst, die in Aufnahmen (64), insbesondere Führungsschienen, im Gehäuse (24) geführt ist und an der eine Schaltplatine (62) aufgenommen ist.

2. Schaltbaugruppe (43) gemäß Anspruch 1, **dadurch gekennzeichnet, dass** das Gehäuse (24) Aufnahmen (64), insbesondere Führungsschienen, aufweist, in welchen sowohl die Schaltplatine (62) als auch die Halteplatte (46) aufgenommen sind.

3. Schaltbaugruppe (43) gemäß den Ansprüchen 1 bis 2, **dadurch gekennzeichnet, dass** die Schaltplatine (62) einen einer Fläche (80) des Schaltknopfes (68) gegenüberliegenden Mikroschalter (44) aufweist.

4. Schaltbaugruppe (43) gemäß den Ansprüchen 1 bis 3, **dadurch gekennzeichnet, dass** der Mikroschalter (44) auf einer Oberseite eines Podestes (60) der Schaltplatine (62) aufgenommen ist.

5. Schaltbaugruppe (43) gemäß den Ansprüchen 1 bis 4, **dadurch gekennzeichnet, dass** der Schaltknopf (68) eine umlaufende Vertiefung (70) aufweist, die durch einen umlaufenden Bund (74) begrenzt ist.

6. Schaltbaugruppe (43) gemäß den Ansprüchen 1 bis 5, **dadurch gekennzeichnet, dass** der umlaufende Bund (74) und die umlaufende Vertiefung (70) des Schaltknopfes (68) mit einer die Gehäuseöffnung (72) begrenzenden Öffnungswand (76) eine Labyrinthdichtung bilden.

7. Schaltbaugruppe (43) gemäß den Ansprüchen 1 bis 6, **dadurch gekennzeichnet, dass** die Schaltplatine (62) an der Halteplatte (46) mit Fixierhaken (58) fixiert ist.

8. Schaltbaugruppe (43) gemäß den Ansprüchen 1 bis 7, **dadurch gekennzeichnet, dass** die Halteplatte (46) Vorsprünge (50, 52) sowie Aufnahmen (64), insbesondere Führungsschienen, umfasst, zwischen welchen ein Grundkörper der Halteplatte (46) mittels der Vorsprünge (50, 52) positionierbar ist.

9. Verwendung der Schaltbaugruppe (43) in einem elektronischen Messgerät (10) zur Messung elektrischer Größen, wobei das elektronische Messgerät (10) als Multimeter, als Zangenamperemeter, als Gabelamperemeter oder als Spannungsmesser zur Messung elektrischer Größen ausgeführt ist, insbesondere von Strömen, Spannungen, elektrischen Widerständen, Kapazitäten, Temperaturen, Impedanzen, in Gleichstrom-oder Wechselstromanwendungen.

10. Elektronisches Messgerät (10) mit einer Schaltbaugruppe (43) gemäß einem der Ansprüche 1 bis 8.
